Europäisches Patentamt

European Patent Office

Office européen des brevets

(19)

(11) Veröffentlichungsnummer : **0 069 112**
**B1**

(12) **EUROPÄISCHE PATENTSCHRIFT**

(45) Veröffentlichungstag der Patentschrift :
07.05.86

(51) Int. Cl.⁴ : **H 01 L 41/18**

(21) Anmeldenummer : **82890087.8**

(22) Anmeldetag : **06.06.82**

(54) **Piezoelektrisches Element.**

(30) Priorität : 24.06.81 AT 2807/81
11.05.82 AT 1854/82

(43) Veröffentlichungstag der Anmeldung :
05.01.83 Patentblatt 83/01

(45) Bekanntmachung des Hinweises auf die Patenterteilung : 07.05.86 Patentblatt 86/19

(84) Benannte Vertragsstaaten :
**CH DE FR GB IT LI NL SE**

(56) Entgegenhaltungen :
**US-A- 4 109 172**
**US-A- 4 109 173**

(73) Patentinhaber : **List, Hans**
**Heinrichstrasse 126**
**A-8010 Graz (AT)**

(72) Erfinder : **Engel, Günter**
**Krengasse 11**
**A-8010 Graz (AT)**
Erfinder : **Krempl, Peter**
**Leonhardstrasse 100/2/7**
**A-8010 Graz (AT)**

(74) Vertreter : **Krause, Walter, Dr. Dipl.-Ing.**
**Margaretenstrasse 21**
**A-1040 Wien (AT)**

**Beschreibung**

Die Erfindung betrifft ein piezoelektrisches Element aus einem piezoelektrischen Kristall der Punktsymmetrieklasse 32 und der chemischen Summenformel $ABO_4$, insbesonders für Einrichtungen wie Ultraschallwandler, Ultraschallsensoren, Schallpulsgeneratoren, akustische Deflektoren, akustische Modulatoren, Kristalloszillatoren, Frequenznormale, Uhren, « Timer », Oberflächenwellengeräte, Aerosolzerstäuber, Sputter-Geräte, Digitalthermometer, Mikrowaagen, Mikro- und Hydrophone, sowie Meßwertaufnehmer zur Messung mechanischer Größen, wie Kraft, Beschleunigung oder Druck.

An piezoelektrische Einrichtungen gestellte Anforderungen können oft durch für den Anwendungszweck angepaßte Konstruktionen und Technologien erfüllt werden. Die Problemstellungen sind dabei von Fall zu Fall verschieden. Einige, das verwendete Piezoelement betreffende Anforderungen, sind jedoch praktisch allen piezoelektrischen Einrichtungen gemeinsam :

Es sind dies folgende Kriterien für Piezoelemente :

1. Temperaturbeständigkeit
2. geringe Temperaturabhängigkeit der « Figure of Merit »
3. hoher Q-Faktor
4. mechanische und chemische Stabilität
5. leichte Bearbeitbarkeit
6. kostengünstige, synthetische Herstellbarkeit
7. keine Pyroelektrizität

Die Temperaturbeständigkeit betrifft dabei nicht nur diejenige der piezoelektrischen Eigenschaften allein, sondern auch andere physikalische Eigenschaften des Piezomaterials. Besonders zu nennen sind dabei die elastischen und dielektrischen Eigenschaften. Eine Erhöhung der Temperaturbeständigkeit gegenüber jetzigen bekannten Piezoelementen ist vom Standpunkt der Ausdehnung des Anwendungstemperaturbereiches der betreffenden piezoelektrischen Einrichtung wünschenswert und ein Teil der der vorliegenden Erfindung zugrundeliegenden Aufgabe.

Am Beispiel piezoelektrischer Meßwertaufnehmer sei dieses Problem näher erläutert :

Für piezoelektrische Meßwertaufnehmer wird gegenwärtig fast ausschließlich Quarz als Material für die piezoempfindlichen Meßelemente verwendet, weil dieses Material mechanisch, chemisch und thermisch widerstandsfähig ist, einen hohen Isolationswiderstand besitzt, sich synthetisch in großen Einkristallen herstellen läßt und relativ gut bearbeitbar ist. Ein weiterer Vorteil von Quarz in diesem Zusammenhang besteht darin, daß der Temperaturverlauf der effektiven piezoelektrischen Konstanten durch geeignete Wahl der Kristallorientierung kompensierbar ist. Es treten jedoch vor allem unter thermisch-mechanischen dynamischen Belastungen, wie beispielsweise beim Einsatz derartiger Meßwertaufnehmer zur Druckmessung an Brennkraftmaschinen, bei Temperaturen oberhalb von etwa 200 °C verschiedene gravierende Nachteile auf, die eine sinnvolle Messung nur mehr unter Sicherstellung einer zumindest konstruktiv sehr aufwendigen Kühlung des Bereiches der Meßelemente erlauben. So sinkt beispielsweise der Isolationswiderstand bei erhöhter Temperatur merkbar ab, was zum Teil durch die erhöhte Eigenleitfähigkeit des Quarzes verursacht ist, es treten thermo-elektrische Spannungen auf und es werden Sprünge in der Empfindlichkeit durch die verstärkt auftretende Zwillingsbildung im Quarz bewirkt. Während der Verlust an Isolationsfähigkeit und die Störungsspannungen sich durch verschiedene bekannte Maßnahmen vermeiden lassen bzw. für das piezoelektrische Meßelement ohnedies unspezifisch sind, sind zur Unterdrückung der störenden Zwillingsbildung zwar verschiedene Maßnahmen bekannt, welche jedoch allesamt nur zu einer leichten Verschiebung dieses Effektes in höhere Temperaturbereiche und damit zu keiner Vermeidung der damit einhergehenden Nachteile führen.

Aus diesem Grunde sind auch Hochtemperaturdruckgeber bekannt, welche mit Lithiumniobat als piezoelektrischem Meßelement ausgerüstet sind, welches ferroelektrisch ist, ausgezeichnete elektromechanische Eigenschaften besitzt und bis etwa 1 200 °C piezoelektrisch ist. Lithiumniobat besitzt jedoch einige markante Nachteile ; aufgrund seiner großen Anisotropie in den Ausdehnungskoeffizienten ist dieser Kristall sehr empfindlich auf thermische Belastungen, womit der Druckgeber nur eine sehr beschränkte Lebensdauer aufweist. Als weiterer Nachteil ist die schlechte Isolation bei höheren Temperaturen zu nennen, welche durch Ionenleitung noch verstärkt wird. Bekannt für die Verwendung in Hochtemperaturgebern ist weiters auch Lithiumtantalat, welches zusätzlich zu den schon bei Lithiumniobat genannten Nachteilen noch eine temperaturabhängige Domänenbildung analog der Zwillingsbildung bei Quarz zeigt. Eine weitere bekannte Möglichkeit besteht in der Verwendung von Turmalin, welches zwar bei höheren Temperaturen als Quarz verwendet werden kann, jedoch keine temperaturkompensierten Schnitte wie Quarz aufweist und sich noch dazu nicht synthetisch herstellen läßt ; natürlich vorkommender Turmalin zeigt abhängig von der Zusammensetzung stark schwankende Eigenschaften und ist ziemlich teuer. Außerdem sind alle obengenannten Kristalle mit Ausnahme des Quarzes pyroelektrisch und es treten daher elektrische Störladungen bei Temperaturänderungen auf, welche aufwendige und nur für bestimmte thermische Zustände wirksame Kompensations-Maßnahmen erfordern.

Piezoelektrische Elemente der eingangs genannten Art, nämlich aus Berlinit ($AlPO_4$), sind

auch beispielsweise aus der US-PS-4 109 172 bekannt, welche in den wesentlichsten Kriterien sehr ähnlich zu Quarz sind, jedoch ebenfalls keine zufriedenstellende Temperaturstabilität der « Figure of Merit » aufweisen.

Ziel der Erfindung ist daher die Angabe von Piezomaterialen, welche nicht nur in allen piezoelektrischen Einrichtungen einsetzbar sind, sondern welche in einfacher und vorteilhafter Weise auch die oben genannten sieben Kriterien erfüllen.

Das bisher in allen der eingangs genannten Anwendungsbeispielen am meisten eingesetzte Material, welches am ehesten die Kriterien 1 bis 7 gemeinsam erfüllt, ist, wie bereits im Zusammenhang mit den als Beispiel behandelten Meßwertaufnehmern zur Druckmessung angeführt, die α-Modifikation von Quarz. Bezüglich der Kriterien 3 bis 7 ist Quarz als konkurrenzlos zu bezeichnen. Aufgrund seines α-β-Phasenüberganges bei 573 °C ist der Bereich der Temperaturbeständigkeit jedoch beschränkt. Weiters ist die Temperaturabhängigkeit der « Figure of Merit » — diese erlaubt in bekannter Weise eine Bewertung der Qualität der gesamten Einrichtung nach bestimmten Gegebenheiten — von piezoelektrischen Einrichtungen welche Quarz enthalten, zu beachten. Insbesonders bei Timern, Frequenznormalen, Frequenzfiltern etc. sind optimierte Kristallschnitte und entsprechende Thermostatisierungen vorzusehen. Einzelne der Kriterien 3 bis 7 könnten für sich ohne weiteres erfüllt werden. Erwähnt seien hier Kristalle der KDP-Familie, für welche Punkt 6 optimal erfüllt ist. Bezüglich der Punkte 1, 2 und vor allem 4 bleiben jedoch diese Kristalle weit unter den üblichen Anforderungen zurück.

Die Hauptaufgabe der Erfindung besteht somit in der Angabe von Materialien, welche in bezug auf die Kriterien 3 bis 7 dem Quarz weitgehend äquivalent sind, ihm jedoch in bezug auf 1 und 2 entscheidend überlegen sind.

Die Erfindung geht davon aus, daß die Temperaturstabilität und die Temperaturabhängigkeit von physikalischen Eigenschaften, welche sich in jener der « Figure of Merit » der entsprechenden piezoelektrischen Einrichtung niederschlagen, durch bestimmte Gegebenheiten im optischen Phononenspektrum der verwendeten Piezokristalle erkennbar ist. Dieser aus einer empirischen Beobachtung folgende Sachverhalt sei im folgenden kurz erläutert :

Ein Piezokristall kann mit einem einfallenden Lichtstrahl derart in Wechselwirkung treten, daß er einen geringen Teil der Lichtenergie aufnimmt und diesen Teil des Lichts mit einer anderen Frequenz, einer anderen Polarisation und in einer relativ beliebigen Richtung wieder abstrahlt.

In einem typischen Experiment dieser Art wird ein intensiver Laserstrahl auf den Piezokristall fokusiert, das in ihm derart gestreute Licht wird gesammelt, gebündelt und nach Durchgang durch ein Spektrometer in einem Fotomultiplier in Strompulse umgewandelt. Diese Strompulse werden sodann gezählt oder integriert. Da als physikalische Ursache für die Frequenzänderung des gestreuten Lichts gegenüber dem einfallenden Licht die Übertragung oder die Aufnahme von Energie und Impuls von Gitterwellen (Phononen) des Piezokristalls auf das Licht angesehen wird, bezeichnet man die Intensitätskurve des gestreuten Lichts über der Frequenzdifferenz als Spektrum inelastisch gestreuter optischer Phononen. Sowohl die Anzahl als auch die Lage von Intensitätsmaxima sind charakteristisch für einen Piezokristall.

Von allen Phononen, welche in einem Kristall angeregt werden können, muß nicht jedes in diesem Spektrum aufscheinen. Von Bedeutung ist die Tatsache, daß zumindest für denjenigen dielektrischen Tensor, der der Punktgruppe des Kristalls entspricht, auf jeden Fall Intensitätsmaxima im Spektrum existieren. Diese sogenannten totalsymmetrischen Phononen-Moden weisen meist auch höhere Intensitäten als Phononen-Moden anderer Symmetrien auf. Die erwähnte bestimmte Gegebenheit besteht nun im Temperaturverhalten der totalsymmetrischen Phononen-Mode mit der niedrigsten Energie.

Der erste Grundgedanke zur überraschend einfachen Lösung der der Erfindung zugrunde liegenden Aufgabe liegt nun darin, das Temperaturverhalten dieses Phononen-Modes mit dem Temperaturverhalten von physikalischen Eigenschaften des Piezokristalls, insbesondere den piezoelektrischen, elastischen und dielektrischen Eigenschaften, in Zusammenhang zu bringen. So können beispielsweise die Energieverluste dieser sogenannten weichen Moden total symmetrischer Symmetrie und niedrigster Energie mit einer verstärkten Neigung zur Zwillingsbildung im Kristall im Zusammenhang gebracht werden, welche ihrerseits im Zusammenhang mit belasteten Druckgebermeßelementen einen der Hauptnachteile der bekannten Piezomaterialien darstellt. Sofern die Frequenz dieses Phononen-Modes im Temperaturbereich von 20 °C bis 500 °C sich um nicht mehr als 15 % ändert, so ist eine erhebliche Verbesserung sowohl der Temperaturbeständigkeit als auch der Temperaturabhängigkeit von physikalischen Größen gegenüber dem Quarz gegeben.

Der zweite einfache Grundgedanke zur Bewältigung der gestellten Aufgabe besteht in der Sicherung der Punkte 3 bis 7 durch Beibehaltung der strukturellen Gegebenheiten des Quarzes, welcher 3 bis 7 ausgezeichnet erfüllt. Dies geschieht durch die Auswahl von Kristallen, welche die Punktsymmetrieklasse 32 besitzen und die chemische Summenformel $ABO_4$ haben.

Die für die Eigenschaften 3 bis 6 besonders günstige tetraedrische Konfiguration, welche auch beim Quarz gegeben ist, wird in sehr einfacher und vorteilhafter Weise durch die in Anspruch 2 angeführte Auswahl von Kristallen erreicht. Diese Kristalle sind weiters, wie auch Quarz, hydrothermal synthetisch herstellbar. Dieses Verfahren ist wesentlich billiger und energiesparender als andere Herstellungsverfahren und die so erzeugten Kristallelemente sind homogener und frei von inneren Spannungen. Gegenüber dem Quarz sind zur Herstellung dieser Kristalle jedoch niedrigere Temperaturen und niedrigere Drücke verwendbar, was die angeführten Vorteile noch verstärkt.

Als Beispiel sei das genannte Aluminiumorthoarsenat (AlAsO$_4$) näher betrachtet:

Wie Quarz oder Berlinit gehört auch dieser Kristall zur Punktsymmetrieklasse 32; die Frequenzen der total symmetrischen Phononen-Moden $w_1$ bis $w_4$, welche denen des Quarz entsprechen, liegen hier bei 225, 335, 450 und 1100 cm$^{-1}$. Eine Betrachtung des Temperaturverhaltens des Kristalles zeigt im Hinblick auf die obigen Ausführungen, daß alle total symmetrischen Moden innerhalb des besagten Temperaturbereiches dem 15 % Stabilitätskriterium gemäß der vorliegenden Erfindung genügen, womit beispielsweise das für die bisher in diesem Zusammenhang bekannten piezoelektrischen Materialien nachteilige Probleme der Zwillingsbildung überhaupt nicht auftritt. Weiters wären noch speziell MnPO$_4$ sowie auch FePO$_4$ und FeAsO$_4$ zu nennen, bei denen ebenfalls die total symmetrischen Phononen-Moden in dem gemäß der vorliegenden Erfindung geforderten Bereich stabil sind.

Die gemäß der vorliegenden Erfindung vorgeschlagenen Piezomaterialien können natürlich auf sämtliche der in diesem Zusammenhang bekannten Weisen eingesetzt werden; hier wäre nur als Beispiel die Messung unter Ausnutzung des longitudinalen oder transversalen piezoelektrischen Effektes, die Ausnützung von verschiedenen Kristallorientierungen sowie die Verwendung in aktiven als auch in passiven piezoelektrischen Einrichtungen anzuführen.

Für die Verwendung als Piezoresonator für z. B. Frequenznormale oder Timer vereinigen diese Materialien die Vorteile von Quarz (hohe Güte, Existenz vom temperaturkompensierten Schnitten) sind diesen jedoch bezüglich der thermischen Stabilität und der Größe des kompensierbaren Temperaturbereiches deutlich überlegen, sodaß eine Thermostatisierung, wie bei entsprechenden Quarz-Frequenznormalen notwendig, hier nicht erforderlich ist.

Auch für Resonatoren in Digitalthermometern eignen sich diese Kristalle vorzüglich, da man Schnitte mit hoher Linearität des thermischen Frequenzganges wählen kann. Zusätzlich erhält man einen wesentlich größeren Temperaturmeßbereich als etwa bei Quarzthermometern.

Bei Verwendung in Druckgebern können nunmehr aufwendige Maßnahmen zur Kühlung der Piezoelemente entfallen, da auch bei höheren Temperaturen keine Zwillingsbildung zu befürchten ist.

In Druckaufnehmern, welche den longitudinalen Piezoeffekt ausnützen, werden eine Anzahl von Piezoelementen elektrisch parallel und mechanisch in Serie zwecks Erhöhung der Empfindlichkeit in Modulbauweise angeordnet. Wegen der höheren intrinsischen Empfindlichkeit der erfindungsgemäß verwendeten Kristalle kann deren Anzahl vorteilhaft reduziert werden.

Entsprechende Druckaufnehmer, welche den transversalen Piezoeffekt ausnutzen, können aus demselben Grund mit Piezoelementen von kleinerem Volumen ausgestattet werden.

Anhand von weiteren Beispielen sei die Überlegenheit der mit der vorliegenden Erfindung vorgeschlagenen Materialien gegenüber bekannten Piezo-Materialien verdeutlicht. In der DE-PS 2 746 712 wird ein piezoelektrischer Resonator beschrieben, dessen Haltestücke gleichzeitig als akustische Impedanzwandler zur Verminderung von Schallverlusten ausgebildet sind. Bei herkömmlichen Materialien für den Resonatorkern sind Maßnahmen zur Temperaturkompensation der Resonanzfrequenz vorzusehen, welche nunmehr wegfallen können und zu einer Vereinfachung des Gesamtaufbaus führen.

Die piezoelektrischen Elemente dieses Resonators, mittels eines Wechselstromgenerators zu akustischen Schwingungen angeregt, schwingen aufgrund des akustischen Abschlusses, mit von mechanischen Umgebungseinflüssen weitgehend unabhängiger Güte. Nachteilig bei der bekannten Verwendung von Quarz ist hier der beschränkte Temperaturbereich bei der Herstellung des Gesamtresonators. Vorteilhafte Sinter und Hochtemperatur-Klebetechniken zur Aufbringung der Abschlußschichten sind erst mit Verwendung der erfindungsgemäßen Elemente einsetzbar.

Weiters ist beispielsweise aus der DE-AS 2 416 085 ein Resonator bekannt, welcher als Kernstück ein Piezoplättchen enthält, welches im Elektrodenbereich eine gegenüber dem übrigen Bereich verschiedene, wirksame Resonatordicke besitzt. Bei Verwendung von Kristallelementen nach der vorliegenden Erfindung ergibt sich folgende Verbesserung. Bei Quarz als z. Zt. günstigstem Material hiefür (wegen des hohen Q-Faktors) ist die Fabrikation dieser unterschiedlichen Resonatordicke mit kostengünstigen Ätztechniken nicht möglich, da das erforderliche Ätzmittel HF (Flußsäure) bedeutende Nachteile mit sich bringt. Diese Nachteile, die Handhabung betreffend, fallen bei Verwendung von Phosphorsäure für GaPO$_4$ bzw. Arsensäure für AlAsO$_4$ und GaAsO$_4$ weg.

Die Verwendung von Elementen nach der vorliegenden Erfindung ist beispielsweise auch in einem Oberflächenwellenplättchen für eine Verzögerungsleitung möglich. Bei bekannten derartigen Anordnungen wird beispielsweise LiNbO$_3$ als Substratmaterial verwendet, welches keinen Schnitt mit temperaturkompensierter Arbeitsfrequenz hat, was eine Temperaturkontrolle notwendig macht. Quarz besitzt solche Schnitte, welche jedoch dazu führen, daß Konzessionen bezüglich der Frequenzbandbreite gemacht werden müssen. Die Verwendung von Kristallen gemäß der vorliegenden Erfindung als Substrat vereint die günstigen Eigenschaften von Quarz mit einer verbesserten « figure of merit », da aufgrund der verminderten Temperaturabhängigkeit aller physikalischen relevanten Größen die damit nicht notwendige Schnittbeschränkung für die Optimierung anderer Größen, wie Bandbreite, Schallgeschwindigkeit oder Kopplungskonstante genutzt werden kann, je nach Frequenzbereich und Anwendung der Oberflächenwelleneinrichtung.

Weitere piezoelektrische Einrichtungen, wo die Vorteile der erfindungsgemäßen Kristalle zum Tragen kommen, sind beispielsweise Mikrowägeeinrichtungen, welche piezoelektrische Resonatoren mit von der Beladung einer Elektrodenschicht oder auch Kristallschicht abhängigen Resonanz oder Antiresonanzfreuquenz enthalten. Für den Einsatz in Sputter oder Aufdampfanlagen, sowie Oberflächenanalysengeräten fallen die für Quarz notwendigen Vorsichtsmaßnahmen (siehe beispielsweise US-PS 3 113 224) weg, welche bei Betrieb bei höheren Temperaturen, wie sie in den genannten Geräten erwünscht sind, getroffen werden müssen.

Mit den gemäß der vorliegenden Erfindung verwendeten Kristallen werden auch Ultraschallgeneratoren und Sensoren für Laufzeit, Durchfluß und Schallmessungen in heißen Medien ohne bei zur Zeit bekannten Geräten nötigen thermischen Schutz möglich. Damit ist die Anordnung von piezoelektrischen Schallwandlern zum Zweck der optimalen Übertragung direkt an einem heißen Medium möglich. Thermischer Schutz bei Pulslaufzeitmessungen bekannter Art bei heißen Durchflußmedien und Temperaturkompensation bei wechselnden Temperaturen wird unnötig oder wenigstens erheblich erleichtert.

Dasselbe gilt für Ultraschallpulsgeber oder -empfänger, die an heißen Festkörpern Aufgaben übernehmen sollen, z. B. Empfang von gestreuten Schallwellen von Mikrorissen in Hochtemperaturkesselanlagen.

Eine bekannte Anordnung zur Messung der Partikelkonzentrationen in Gasen kann mit Verwendung von Schallwellengeneratoren und -empfängern auf der Basis von Kristallen gemäß der vorliegenden Erfindung auf einfache Weise auch zur Partikelmessung an heißen Abgasen eingesetzt werden.

Die Beispiele zeigen die Vielfalt der Einsatzbereiche von Materialien, welche durch die mit der vorliegenden Erfindung angegebenen Kennzeichen charakterisiert sind.

## Patentansprüche

1. Piezoelektrisches Element aus einem piezoelektrischen Kristall der Punktsymmetrieklasse 32 und der chemischen Summenformel $ABO_4$, dadurch gekennzeichnet, daß der piezoelektrische Kristall im Bereich von 20 °C bis 500 °C eine Frequenzverschiebung des totalsymmetrischen optischen Phononen-Modes mit der niedrigsten Frequenz um höchstens 15 % aufweist.

2. Piezoelektrisches Element nach Anspruch 1, dadurch gekennzeichnet, daß der piezoelektrische Kristall aus der Gruppe : $GaAsO_4$, $GaPO_4$, $AlAsO_4$, $FeAsO_4$, $FePO_4$, $MnPO_4$, $MnAsO_4$ stammt.

## Claims

1. A piezoelectric element comprising a piezoelectric crystal of point group 32 and the total molecular formula $ABO_4$, wherein said crystal is characterized by a frequency shift of the totally symmetric optical phonon mode of the lowest frequency by no more than 15 percent within the temperature range of 20-500 °C.

2. A piezoelectric element as in claim 1, wherein the piezoelectric crystal belongs to the group : $GaAsO_4$, $GaPO_4$, $AlAsO_4$, $FeAsO_4$, $FePO_4$, $MnPO_4$, $MnAsO_4$.

## Revendications

1. Elément piézo-électrique constitué d'un cristal piézo-électrique de la classe 32 de symétrie ponctuelle et de formule chimique brute $ABO_4$, caractérisé en ce que le cristal piézo-électrique présente, dans la zone de 20 à 500 °C, un décalage de fréquence du mode de symétrie totale optique des phonons dont la fréquence la plus basse est au maximum de 15 %.

2. Elément piézo-électrique suivant la revendication 1, caractérisé en ce que le cristal piézo-électrique provient du groupe formé par les : $GaAsO_4$, $GaPO_4$, $AlAsO_4$, $FeAsO_4$, $FePO_4$, $MnPO_4$, $MnAsO_4$.